# EUROPÄISCHE PATENTSCHRIFT

(11) **EP 3 401 956 B1**
(45) Veröffentlichungstag und Bekanntmachung des Hinweises auf die Patenterteilung: **27.05.2020**
(21) Anmeldenummer: 18160074.3
(22) Anmeldetag: 06.03.2018
(51) Int. Cl.: H01L 23/473, H01M 10/6567

(54) **LEISTUNGSHALBLEITERMODUL FÜR EIN KRAFTFAHRZEUG UND KRAFTFAHRZEUG**
POWER SEMICONDUCTOR MODULE FOR A MOTOR VEHICLE AND MOTOR VEHICLE
MODULE DE SEMI-CONDUCTEUR DE PUISSANCE POUR UN VÉHICULE AUTOMOBILE ET VÉHICULE AUTOMOBILE

(30) Priorität: 11.05.2017 DE 102017207962
(43) Veröffentlichungstag der Anmeldung: 14.11.2018
(73) Patentinhaber: AUDI AG, 85045 Ingolstadt (DE)
(72) Erfinder: Straßer, Roman, 85080 Gaimersheim (DE)

(56) Entgegenhaltungen:
- DE-A1-102008 026 550
- JP-A- 2008 041 806
- US-A- 5 448 108

## Beschreibung

Die Erfindung betrifft ein Leistungshalbleitermodul für ein Kraftfahrzeug und ein Kraftfahrzeug.

Leistungshalbleitermodule in Kraftfahrzeugen weisen typischerweise mehrere Leistungshalbleiterchips auf und werden als Schalteinheiten für Stromrichter, wie Gleichrichter oder Pulswechselrichter, verwendet. Bei teilweise oder vollständig elektrisch angetriebenen Kraftfahrzeugen kann ein Leistungshalbleitermodul beispielsweise zur Erzeugung eines mehrphasigen Wechselstroms aus der Ausgangsspannung einer Hochvoltbatterie oder zum Wandeln eines Wechselstroms in eine Ladegleichspannung für eine Hochvoltbatterie verwendet werden. Dabei erwärmen sich Leistungshalbleiterchips erheblich und müssen zur Vermeidung einer Beschädigung gekühlt werden.

Es ist bekannt die Leistungshalbleiterchips auf einem Kühlkörper anzuordnen, welcher z. B. als massiver Metallblock, insbesondere aus Aluminium, ausgebildet ist und z. B. gebohrte, gegossene oder gefräste Kühlkanäle aufweist. Die Kühlkanäle werden von einer Kühlflüssigkeit durchströmt und führen wegen der thermischen Kopplung des Kühlkörpers mit den Leistungshalbleiterchips die Wärme von diesen ab. Um einen Kontakt der Kühlflüssigkeit mit den Leistungshalbleiterchips zu vermeiden, werden hohe Anforderungen an die Dichtigkeit von Kühlflüssigkeitszuleitungen zum Kühlkörper gestellt. Besonders aufwändig ist hierbei die Verwendung besonderer Dichtungen für die Kühlflüssigkeitszuleitungen und elektrisch isolierender Kühlflüssigkeiten, wie Isolieröl. Die thermische Kopplung der Leistungshalbleiterchips mit dem Kühlkörper erfolgt zudem nur über einen langen Wärmeübertragungspfad von den Leistungshalbleiterchips über eine, beispielsweise aus Kunststoff, einem Keramiksubstrat oder einem anderen Trägermaterial gebildete, Trägerplatte, beispielsweise ein Keramiksubstrat, und ein Wärmeleitpad oder eine Wärmeleitpaste zum Kühlkörper, was die Wärmeübertragung nachteilig hemmt.

Die Dokumente JP2008041806 A und DE 10 2008 026 550 A1 offenbaren eine Kühlanordnung für Leistungshalbleitermodule.

Der Erfindung liegt mithin die Aufgabe zugrunde, ein effizient und aufwandsarm zu kühlendes Leistungshalbleitermodul für ein Kraftfahrzeug anzugeben. Zur Lösung dieser Aufgabe ist erfindungsgemäß bei einem Leistungshalbleitermodul der eingangs genannten Art vorgesehen, dass mehrere ungehäuste Leistungshalbleiterchips vorgesehen sind, die von einer durch eine Kühlflüssigkeitszuleitung in das Leistungshalbleitermodul eingeleiteten Kühlflüssigkeit unmittelbar umströmbar angeordnet sind.

Die Erfindung beruht auf der Überlegung, die Leistungshalbleiterchips unmittelbar durch die zweckmäßigerweise elektrisch isolierende Kühlflüssigkeit umströmen zu lassen und so eine Direktkühlung zu realisieren. Die Leistungshalbleiterchips sind erfindungsgemäß ungehäust ausgebildet, beispielsweise als Bare Dies, so dass ein zusätzlicher die Wärmeübertragung zur Kühlflüssigkeit hemmender Wärmeübertragungspfad durch ein Chipgehäuse entfällt. Ebenso kann durch die Direktkühlung der Leistungshalbleiterchips auf einen Kühlkörper mit aufwändigen Dichtungen und Wärmeübertragungsmitteln, wie Wärmeleitpads oder Wärmeleitpasten, verzichtet werden. Das erfindungsgemäße Leistungshalbleitermodul kann vorteilhafterweise aufwandsärmer gefertigt werden, da ein Chipgehäuse, ein Kühlkörper und zugehörige Dichtungen entfallen können. Gleichzeitig wird eine besonders effiziente Kühlung der Leistungshalbleiterchips direkt an ihrer Chipoberfläche ohne zusätzliche Wärmeübertragungspfade zwischen dieser und der Kühlflüssigkeit ermöglicht.

Bevorzugt bilden die Leistungshalbleiterchips Leistungstransistoren aus. Dabei kann es sich beispielsweise um Bipolartransistoren mit isoliertem Gate (IGBT) oder Feldeffekttransistoren mit isoliertem Gate, wie Leistungs-MOSFETS, handeln. Ein Leistungshalbleiterchip kann dabei einen Einzeltransistor oder eine Schaltung mehrerer Einzeltransistoren realisieren. Alternativ oder zusätzlich können die Leistungshalbleiterchips Freilaufdioden, welche bevorzugt den Leistungstransistoren zugeordnet sind, ausbilden, um diese analog zu kühlen.

Im Hinblick auf die Verwendung des Halbleitermoduls als Stromrichter in einem Kraftfahrzeug wird es bevorzugt, wenn die Leistungshalbleiterchips zu einer Brückenschaltung, insbesondere einer Halbbrücke oder einer B6-Brücke, verschaltet sind. Das Leistungshalbleitermodul kann dazu eine Steuerschaltung oder einen Steuereingang für Steuersignale einer externen Steuereinrichtung zur Ansteuerung des Leistungshalbleiterchips aufweisen.

Bei dem erfindungsgemäßen Leistungshalbleitermodul ist zweckmäßigerweise ein Trägerelement vorgesehen, auf welchem die Leistungshalbleiterchips angeordnet sind. Dabei wird es bevorzugt, wenn das Trägerelement auf seiner die Leistungshalbleiterchips aufweisenden Seite oder beidseitig durch die Kühlflüssigkeit umströmbar innerhalb des Leistungshalbleitermoduls angeordnet ist. Es kann so mit Vorteil auch die an das Trägerelement abgegebene Wärme durch die umströmende Kühlflüssigkeit abgeführt werden.

Gemäß einer ersten Ausgestaltungsvariante weist das Trägerelement einen Kühlkörper mit wenigstens einem durch die Kühlflüssigkeit durchströmbaren Kühlkanal auf. Es ist also auch bei der erfindungsgemäßen Direktkühlung dennoch die Verwendung eines herkömmlichen Kühlkörpers möglich, um eine zusätzliche Wärmeabfuhr auf der nicht mit der Kühlflüssigkeit unmittelbar in Kontakt stehenden Seite der Leistungshalbleiterchips zu erlauben. Die Kühlkanäle können gebohrt, gegossen oder gefräst im Kühlkörper ausgebildet sind. Dieser ist beispielsweise ein Metallblock, bevorzugt aus Aluminium. Das einen Kühlkörper umfassende Trägerelement kann zusätzlich eine Trägerplatte umfassen, auf welcher die Leistungshalbleiterchips befestigt sind. Der Kühlkanal kann flüssigkeitsleitend mit der oder einer Kühlflüssigkeitszuleitung und/oder mit der oder einer Kühlflüssigkeitsableitung verbunden sein, um die Kühlflüssigkeit vom Äußeren des Gehäuses in die Kühlkanäle einzuleiten bzw. aus den Kühlkanälen zum Äußeren des Gehäuses abzuleiten. Eine weitere Ausgestaltungsvariante sieht vor, dass das Trägerelement eine Trägerplatte ist. Das heißt, dass kein mit den Leistungshalbleiterchips mechanisch verbundener Kühlkörper vorgesehen ist. Die Wärmeübertragung von den Leistungshalbleiterchips an die Kühlflüssigkeit erfolgt in dieser Ausgestaltungsvariante mithin ausschließlich unmittelbar durch den Kontakt der Kühlflüssigkeit mit den Leistungshalbleiterchips und ggf. durch den Kontakt der Kühlflüssigkeit mit der Trägerplatte.

Bei beiden Ausgestaltungsvarianten kann die Trägerplatte ein Keramiksubstrat oder aus einem anderen geeigneten Trägermaterial gebildet sein. Die Trägerplatte kann auch eine Leiterplatte aus einem Kunststoff sein. Ferner kann die Trägerplatte Leiterbahnen aufweisen. Die Leiterbahnen können durch Kontaktierungsdrähte mit den Leistungshalbleiterchips elektrisch leitfähig verbunden sind. Die Trägerplatte kann ferner Kontaktelemente zur externen elektrischen Kontaktierung der Leistungshalbleiterchips aufweisen.

Bevorzugt ist bei dem erfindungsgemäßen Leistungshalbleitermodul ferner ein die Leistungshalbleiterchips aufnehmendes Gehäuse vorgesehen ist, an welchem die Kühlflüssigkeitszuleitung ausgebildet ist. Das Gehäuse ist bevorzugt flüssigkeitsdicht ausgebildet. Es kann auch eine Kühlflüssigkeitsableitung aufweisen. Über die Kühlflüssigkeitszuleitung und die Kühlflüssigkeitsableitung kann das Leistungshalbleitermodul mit einer, bevorzugt kraftfahrzeugseitigen, Kühlvorrichtung zur Ausbildung eines geschlossenen Kühlkreislaufs verbunden oder verbindbar sein.

Das Gehäuse kann ferner einen ersten Gehäuseabschnitt aufweisen, an welchem die Kühlflüssigkeitszuleitung und/oder die Kühlflüssigkeitsableitung vorgesehen sind, und einen zweiten Gehäuseabschnitt aufweisen, der vom ersten Gehäuseabschnitt flüssigkeitsdicht getrennt ausgebildet ist. Der zweite Gehäuseabschnitt wird mithin nicht von der Kühlflüssigkeit durchströmt. Der zweite Gehäuseabschnitt kann beispielsweise nicht durch die Kühlflüssigkeit zu kühlende Komponenten, wie beispielweise die Steuerschaltung, aufnehmen.

Die der Erfindung zugrundeliegende Aufgabe wird ferner erfindungsgemäß gelöst durch ein Kraftfahrzeug, umfassend wenigstens eine Batterie und wenigstens einen mit der Batterie verschalteten, ein erfindungsgemäßes Leistungshalbleitermodul aufweisenden Stromrichter. Bevorzugt ist als Batterie eine Hochvoltbatterie für einen elektrischen Antrieb des Kraftfahrzeugs und/oder eine Niedervoltbatterie zur Versorgung eines Bordnetzes, insbesondere mit einer Nennspannung von 48 Volt, vorgesehen. Unter einer Hochvoltbatterie ist eine Batterie mit einer Nennspannung von wenigstens 60 Volt, bevorzugt wenigstens 100 Volt, zu verstehen. Unter einer Niederspannungsbatterie ist eine Batterie mit einer Nennspannung von weniger als 60 Volt, beispielsweise 12 Volt, 24 Volt oder 48 Volt, zu verstehen.

Sämtliche Ausführungen zum erfindungsgemäßen Leistungshalbleitermodul lassen sich analog auf das erfindungsgemäße Kraftfahrzeug übertragen, so dass auch mit diesem die zuvor genannten Vorteile realisiert werden können.

Weitere Vorteile und Einzelheiten der Erfindung ergeben sich aus den im Folgenden beschriebenen Ausführungsbeispielen sowie anhand der Zeichnungen. Diese sind schematische Darstellungen und zeigen:
- Fig. 1: eine Prinzipskizze eines ersten Ausführungsbeispiels eines erfindungsgemäßen Leistungshalbleitermoduls;
- Fig. 2: eine Prinzipskizze eines weiteren Ausführungsbeispiels eines erfindungsgemäßen Leistungshalbleitermoduls; und
- Fig. 3: eine Prinzipskizze eines erfindungsgemäßen Kraftfahrzeugs.

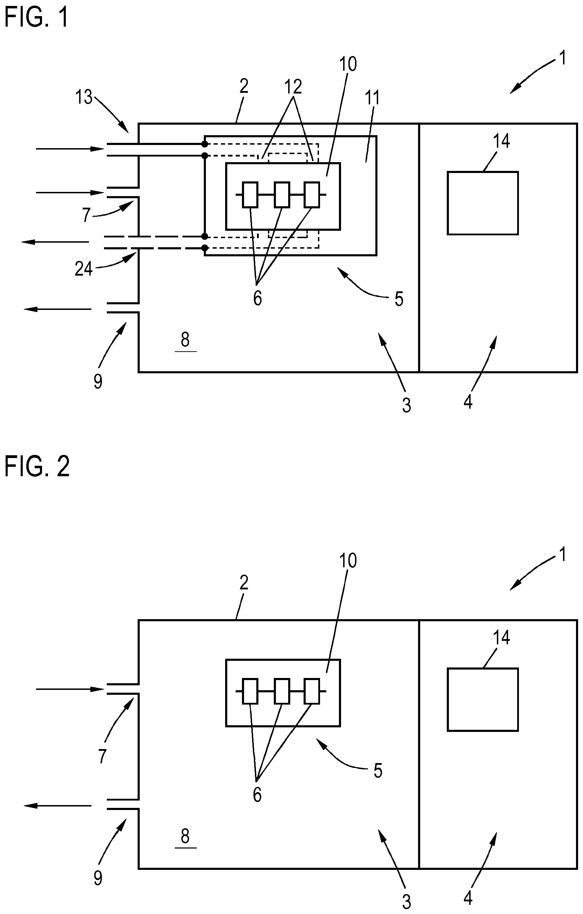

Fig. 1 zeigt eine Prinzipskizze eines ersten Ausführungsbeispiels eines Leistungshalbleitermoduls 1, umfassend ein Gehäuse 2 mit einem ersten Gehäuseabschnitt 3 und einem zweiten Gehäuseabschnitt 4.

Im ersten Gehäuseabschnitt 3 sind mehrere auf einem Trägerelement 5 angeordnete ungehäuste Leistungshalbleiterchips 6, beispielsweise als Bare Dies ausgebildete IGBT oder Leistungs-MOSFET mit zugeordneten Feilaufdioden, aufgenommen. Die Leistungshalbleiterchips 6 sind rein schematisch dargestellt und zu einer Brückenschaltung, beispielsweise einer Halbbrücke oder einer B6-Brücke, verschaltet. Der erste Gehäuseabschnitt 3 weist ferner eine Kühlflüssigkeitszuleitung 7 auf, mittels welcher der flüssigkeitsdicht gekapselte Innenraum des ersten Gehäuseabschnitts 3 mit einer elektrisch isolierenden Kühlflüssigkeit 8 geflutet wird. Das Kühlflüssigkeit 8 umströmt mithin die ungehäusten Leistungshalbleiterchips 6 unmittelbar und führt so die von diesen währenden des Betriebs erzeugte Wärme ab. Zum Abfluss der Kühlflüssigkeit ist eine Kühlflüssigkeitsableitung 9 vorgesehen, an welche eine externe Kühlvorrichtung zur Realisierung eines geschlossenen Kühlkreislaufs mit der Kühlflüssigkeitszuleitung 7 anschließbar ist.

Das Trägerelement 5 umfasst eine, beispielsweise als Keramiksubstrat ausgebildete, Trägerplatte 10, auf welcher die Leistungshalbleiterchips 6 befestigt und extern kontaktierbar sind, und einen Kühlkörper 11, auf welchem die Trägerplatte 10 angeordnet ist. Die Trägerplatte 10 ist, beispielsweise durch ein Wärmeübertragungsmittel, wie ein Wärmeleitpad oder eine Wärmeleitpaste, thermisch mit dem mehrere Kühlkanäle 12 in seinem Inneren aufweisenden Kühlkörper 11 gekoppelt.

Die Kühlkanäle 12 werden ebenfalls durch die Kühlflüssigkeit 8 durchströmt, wozu das Gehäuse eine weiteren Kühlflüssigkeitszuleitung 13 aufweist. Alternativ oder zusätzlich zur weiteren Kühlflüssigkeitszuleitung 13 ist eine gestrichelt gezeigte weitere Kühlflüssigkeitsableitung 24 vorgesehen. Die Kühlflüssigkeitszuleitungen 7 und 13 können auch als gemeinsame Kühlflüssigkeitszuleitung ausgebildet sein. Entsprechend können auch die Kühlflüssigkeitsableitungen 9 und 24 als gemeinsame Kühlflüssigkeitsableitung ausgebildet sein. Es ist auch möglich, auf die weitere Kühlflüssigkeitszuleitung 13 und die weitere Kühlflüssigkeitsableitung 24 zu verzichten. In diesem Fall kann die Kühlflüssigkeit 8 durch die Kühlflüssigkeitszuleitung 7 in das Gehäuse 2 strömen, von dort auch die Kühlkanäle 12 durchströmen und dann durch die Kühlflüssigkeitsableitung 9 aus dem Gehäuse 2 strömen.

Der zweite Gehäuseabschnitt 4 ist flüssigkeitsdicht vom ersten Gehäuseabschnitt 3 getrennt und nimmt eine Steuerschaltung 14, welche zur Ansteuerung der Leistungshalbleiterchips 6 ausgebildet und mit diesen elektrisch leitfähig verbunden ist auf. Da die Steuerschaltung 14 eine geringere Abwärme als die Leistungshalbleiterchips 6 produziert kann hier auf eine Direktkühlung durch die Kühlflüssigkeit 8 verzichtet werden. Auf den zweiten Gehäuseabschnitt 4 kann auch insgesamt verzichtet werden, wenn die Steuerschaltung 14 ebenfalls im ersten Gehäuseabschnitt 3 angeordnet wird oder eine externe Steuereinrichtung verwendet wird.

Fig. 2 zeigt ein weiteres Ausführungsbeispiel eines Leistungshalbleitermoduls 1, welches dem in Fig. 1 Gezeigten entspricht und sich von diesem dadurch unterscheidet, dass das Trägerelement 5 lediglich durch die Trägerplatte 10 gebildet ist. Es wird mithin auf einen zusätzlichen Kühlkörper verzichtet. Die Kühlflüssigkeit 8 umströmt hier die Trägerplatte 10 sowohl auf der die Leistungshalbleiterchips 6 tragenden Seite als auch auf der Rückseite.

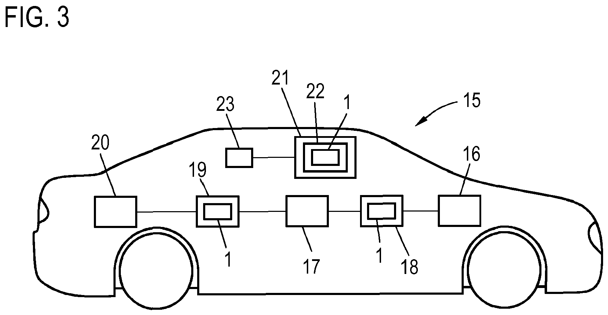

Fig. 3 zeigt eine Prinzipskizze eines Ausführungsbeispiels eines Kraftfahrzeugs 15, umfassend eine elektrische Maschine 16 zum vollständigen oder teilweisen Antrieb des Kraftfahrzeugs 15 und eine Hochvoltbatterie 17 mit einer Nennspannung von wenigstens 60 Volt. Die Hochvoltbatterie 17 und die elektrische Maschine 16 sind durch einen Stromrichter 18 in Form eines Pulswechselrichters verbunden, welcher ein Leistungshalbleitermodul 1 gemäß einem der vorgenannten Ausgangsbeispiele aufweist. Die Batterie 17 ist ferner über einen weiteren Stromrichter 19, welcher ebenfalls wenigstens ein Leistungshalbleitermodul 1 aufweist und Teil eines Ladegeräts ist, mit einem Ladeanschluss 20 des Kraftfahrzeugs 15 verbunden. Ein weiterer Stromrichter 21 mit wenigstens einem Leistungshalbleitermodul 1 ist Teil eines Bordnetzes 22 mit einer Nennspannung von beispielsweise 48 Volt, welches durch eine entsprechende Niedervoltbatterie 23 gespeist wird.

## Patentansprüche

1. Leistungshalbleitermodul für ein Kraftfahrzeug, wobei mehrere ungehäuste Leistungshalbleiterchips (6) vorgesehen sind, die von einer durch eine Kühlflüssigkeitszuleitung (7) in das Leistungshalbleitermodul (1) eingeleiteten Kühlflüssigkeit (8) unmittelbar umströmbar angeordnet sind, **dadurch gekennzeichnet**,
das ein Trägerelement (5) vorgesehen ist, auf welchem die Leistungshalbleiterchips (6) angeordnet sind, wobei das Trägerelement (5) einen Kühlkörper (11) mit wenigstens einem durch die Kühlflüssigkeit (8) durchströmbaren Kühlkanal (12) aufweist.

2. Leistungshalbleitermodul nach Anspruch 1,
**dadurch gekennzeichnet,**
**dass** die Leistungshalbleiterchips (6) Leistungstransistoren und/oder Freilaufdioden ausbilden.

3. Leistungshalbleitermodul nach Anspruch 2,
**dadurch gekennzeichnet,**
**dass** die Leistungstransistoren Bipolartransistoren mit isoliertem Gate oder Feldeffekttransistoren mit isolierten Gate sind.

4. Leistungshalbleitermodul nach einem der vorhergehenden Ansprüche,
**dadurch gekennzeichnet,**
**dass** die Leistungshalbleiterchips (6) zu einer Brückenschaltung verschaltet sind.

5. Leistungshalbleitermodul nach Anspruch 4,
**dadurch gekennzeichnet,**
**dass** die Brückenschaltung eine Halbbrücke oder eine B6-Brücke ist.

6. Leistungshalbleitermodul nach einem der vorhergehenden Ansprüche,
**dadurch gekennzeichnet,**
**dass** das Trägerelement (5) auf seiner die Leistungshalbleiterchips (6) aufweisenden Seite oder beidseitig durch die Kühlflüssigkeit (8) umströmbar innerhalb des Leistungshalbleitermoduls (1) angeordnet ist.

7. Leistungshalbleitermodul nach einem der vorhergehenden Ansprüche,
**dadurch gekennzeichnet,**
**dass** das Trägerelement eine Trägerplatte (10) ist.

8. Leistungshalbleitermodul nach einem der vorhergehenden Ansprüche,
**dadurch gekennzeichnet,**
**dass** ein die Leistungshalbleiterchips (6) aufnehmendes Gehäuse (2) vorgesehen ist, an welchem die Kühlflüssigkeitszuleitung (7) ausgebildet ist.

9. Kraftfahrzeug, umfassend wenigstens eine Batterie (17, 23) und wenigstens einen mit der Batterie (17, 23) verschalteten, ein Leistungshalbleitermodul (1) nach einem der vorhergehenden Ansprüche aufweisenden Stromrichter (18, 19, 21).

10. Kraftfahrzeug nach Anspruch 9,
**dadurch gekennzeichnet,**
**dass** als Batterie eine Hochvoltbatterie (17) für einen elektrischen Antrieb des Kraftfahrzeugs (15) und/oder eine Niedervoltbatterie (23) zur Versorgung eines Bordnetzes vorgesehen sind.

11. Kraftfahrzeug nach Anspruch 10,
**dadurch gekennzeichnet,**
**dass** die Niedervoltbatterie (23) eine Nennspannung von 48 Volt aufweist.

## Claims

1. Power semiconductor module for a motor vehicle, wherein
a plurality of unhoused power semiconductor chips (6) are provided, which are arranged so that a cooling liquid (8) that is introduced into the power semiconductor module (1) through a cooling liquid feed line (7) can circulate directly around them, **characterised in that** a carrier element (5) is provided, on which the power semiconductor chips (6) are arranged, wherein the carrier element (5) has a cooling body (11) with at least one cooling channel (12) through which the cooling liquid (8) can circulate.

2. Power semiconductor module according to claim 1,
**characterised in that**
the power semiconductor chips (6) form power transistors and/or free-wheeling diodes.

3. Power semiconductor module according to claim 2,
**characterised in that**
the power transistors are isolated gate bipolar transistors or isolated gate field effect transistors.

4. Power semiconductor module according to any of the preceding claims,
**characterised in that**
the power semiconductor chips (6) are connected to form a bridge circuit.

5. Power semiconductor module according to claim 4,
**characterised in that**
the bridge circuit is a half-bridge or a B6 bridge.

6. Power semiconductor module according to any of the preceding claims,
**characterised in that**
the carrier element (5) is arranged so that the cooling liquid (8) can circulate around it on its side having the power semiconductor chips (6) or on both sides within the power semiconductor module (1).

7. Power semiconductor module according to any of the preceding claims,
**characterised in that**
the carrier element is a carrier plate (10).

8. Power semiconductor module according to any of the preceding claims,
**characterised in that**
a housing (2) that accommodates the power semiconductor chips (6) is provided, on which the cooling liquid feed line (7) is formed.

9. Motor vehicle, comprising at least one battery (17, 23) and at least one current converter (18, 19, 21), which has a power semiconductor module (1) according to any of the preceding claims and is connected to the battery (17, 23).

10. Motor vehicle according to claim 9,
**characterised in that**,
as the battery, a high-voltage battery (17) for an electric drive of the motor vehicle (15) and/or a low-voltage battery (23) for supplying an onboard power supply system are provided.

11. Motor vehicle according to claim 10,
**characterised in that**
the low-voltage battery (23) has a rated voltage of 48 volts.

## Revendications

1. Module de semi-conducteur de puissance pour un véhicule à moteur, dans lequel
plusieurs puces de semi-conducteur de puissance (6) sans boîtier sont prévues, qui sont disposées de manière à pouvoir être entourées directement par un liquide de refroidissement (8) introduit dans le module de semi-conducteur de puissance (1) par une conduite d'amenée de liquide de refroidissement (7), **caractérisé en ce**
**qu'**un élément de support (5) est prévu, sur lequel sont disposées les puces de semi-conducteur de puissance (6), dans lequel l'élément de support (5) présente un corps de refroidissement (11) avec au moins un canal de refroidissement (12) pouvant être traversé par le liquide de refroidissement (8).

2. Module de semi-conducteur de puissance selon la revendication 1,
**caractérisé en ce**
**que** les puces de semi-conducteur de puissance (6) réalisent des transistors de puissance et/ou des diodes de roue libre.

3. Module de semi-conducteur de puissance selon la revendication 2,
**caractérisé en ce**
**que** les transistors de puissance sont des transistors bipolaires avec une grille isolée ou des transistors à effet de champ avec des grilles isolées.

4. Module de semi-conducteur de puissance selon l'une quelconque des revendications précédentes,
**caractérisé en ce**
**que** les puces de semi-conducteur de puissance (6) sont connectées en un montage en pont.

5. Module de semi-conducteur de puissance selon la revendication 4,
**caractérisé en ce**
**que** le montage en pont est un demi-pont ou un pont à six impulsions.

6. Module de semi-conducteur de puissance selon l'une quelconque des revendications précédentes,
**caractérisé en ce**
**que** l'élément de support (5) est disposé à l'intérieur du module de semi-conducteur de puissance (1) sur sa face présentant les puces de semi-conducteur de puissance (6) ou de manière à être entouré de part et d'autre par le liquide de refroidissement (8).

7. Module de semi-conducteur de puissance selon l'une quelconque des revendications précédentes,
**caractérisé en ce**
**que** l'élément de support est une plaque de support (10).

8. Module de semi-conducteur de puissance selon l'une quelconque des revendications précédentes,
**caractérisé en ce**
**qu'**un boîtier (2) logeant les puces de semi-conducteur de puissance (6) est prévu, sur lequel la conduite d'amenée de liquide de refroidissement (7) est réalisée.

9. Véhicule automobile, comprenant au moins une batterie (17, 23) et au moins un convertisseur de puissance (18, 19, 21) connecté à la batterie (17, 23), présentant un module de semi-conducteur de puissance (1) selon l'une quelconque des revendications précédentes.

10. Véhicule à moteur selon la revendication 9,
**caractérisé en ce**
**qu'**une batterie haute tension (17) pour un entraînement électrique du véhicule à moteur (15) et/ou une batterie basse tension (23) pour l'alimentation d'un réseau de bord sont prévues en tant que batterie.

11. Véhicule à moteur selon la revendication 10,
**caractérisé en ce**
**que** la batterie basse tension (23) présente une tension nominale de 48 volts.
